(19) Europäisches Patentamt / European Patent Office / Office européen des brevets

(11) **EP 4 117 178 A1**

(12) **DEMANDE DE BREVET EUROPEEN**

(43) Date de publication:
**11.01.2023 Bulletin 2023/02**

(21) Numéro de dépôt: **22182935.1**

(22) Date de dépôt: **05.07.2022**

(51) Classification Internationale des Brevets (IPC):
**H03F 1/32** (2006.01)   **G06N 3/08** (2006.01)
**H03F 3/189** (2006.01)   **H03F 3/24** (2006.01)
**H04B 1/04** (2006.01)   **H04L 27/36** (2006.01)

(52) Classification Coopérative des Brevets (CPC):
**H03F 1/3282; G06N 3/08; H03F 1/3247;**
**H03F 3/189; H03F 3/24; H04B 1/0475;**
**H04L 27/368;** H03F 2200/451; H03F 2201/3227;
H03F 2201/3231

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: **05.07.2021 FR 2107230**

(71) Demandeur: **Commissariat à l'énergie atomique et aux énergies alternatives
75015 Paris (FR)**

(72) Inventeurs:
• **FALEMPIN, Alexis**
  **38054 Grenoble Cedex 9 (FR)**
• **Zayani, Rafik**
  **38054 Grenoble Cedex 9 (FR)**
• **Doré, Jean-Baptiste**
  **38054 Grenoble Cedex 9 (FR)**

(74) Mandataire: **Lavoix
2, place d'Estienne d'Orves
75441 Paris Cedex 09 (FR)**

(54) **DISPOSITIF DE LINÉARISATION, PAR PRÉDISTORSION NUMÉRIQUE, D'UN AMPLIFICATEUR DE PUISSANCE D'UN SYSTÈME DE COMMUNICATION**

(57) L'invention concerne un dispositif (18) de linéarisation, par prédistorsion numérique, d'un amplificateur de puissance, comprenant :
- un module (30) de prédistorsion numérique, configuré pour déterminer en inférence une prédistorsion dans le domaine polaire à appliquer à un signal, et comprenant un premier réseau de neurones (32) et un deuxième réseau de neurones (34) respectivement configurés pour corriger une distorsion en amplitude, et en phase, produites par l'amplificateur;

- un module d'optimisation (36) de chacun desdits réseaux de neurones (32, 34) configuré pour mettre en œuvre, un méta-apprentissage, en utilisant :
- une méta-initialisation fournissant au préalable une initialisation des poids initiaux de chacun desdits réseaux de neurones (32, 34) ;
- une méta-adaptation des poids initiaux en poids optimaux de chacun desdits réseaux de neurones (32, 34).

FIG.2

EP 4 117 178 A1

**Description**

La présente invention concerne un dispositif de linéarisation, par prédistorsion numérique, d'un amplificateur de puissance d'un système de communication comprenant au moins un émetteur radiofréquence propre à transmettre au moins une trame de symboles.

La présente invention concerne également un système de communication, un procédé de linéarisation et un programme d'ordinateur associé.

L'invention se situe dans le domaine de l'amplification de puissance mise en œuvre pour des systèmes de communication sans fil. En effet, en transmission, l'amplificateur de puissance est configuré pour fournir suffisamment de puissance au signal transmis afin que celui-ci puisse parvenir correctement jusqu'à destination. De par ce rôle, l'amplificateur de puissance est le plus important consommateur d'énergie de la chaine de transmission, car en effet propre à consommer jusqu'à 80% de la puissance totale consommée par la chaîne de transmission.

De ce fait, la consommation d'un amplificateur de puissance impacte directement la durée d'utilisation des batteries des terminaux mobiles, ou la consommation énergétique d'un opérateur mobile, et l'un des objectifs de la présente invention est d'améliorer de manière significative l'efficacité en puissance d'un amplificateur de puissance radiofréquence de sorte à améliorer globalement l'efficacité énergétique globale des systèmes de communication sans fil et par la même d'en réduire l'empreinte carbone.

En particulier, il est à noter qu'un amplificateur de puissance radiofréquence présente des distorsions non linéaires, notamment en amplitude et en phase, lorsqu'il fonctionne à proximité de son niveau de saturation où son rendement énergétique est également le plus élevé, ce qui impose de trouver le meilleur compromis entre linéarisation et rendement énergétique.

Pour améliorer la linéarisation, des techniques ont été proposées dont la prédistorsion numérique (de l'anglais *digital predistorsion*) consistant à ajouter un module en amont de l'amplificateur de puissance, de sorte que le signal, fourni en sortie de la combinaison de ce module de prédistorsion suivi de l'amplificateur, est sensiblement linéaire.

Toutefois, la conception du module de prédistorsion numérique, propre à fournir une caractéristique inverse de celle de l'amplificateur de puissance de sorte à en compenser les distorsions, est le plus souvent complexe.

Des solutions de conception de module de prédistorsion numérique basées sur l'utilisation de réseaux de neurones propres à la résolution de problèmes non linéaires ont été investiguées, mais de telles solutions sont jusqu'ici inadaptées lorsque l'on considère des amplificateurs dont le fonctionnement varie dans le temps et/ou en fonction de leur contexte d'utilisation.

En effet, d'une part, les solutions actuelles basées sur l'utilisation de réseaux de neurones fournissent une bonne estimation de la caractéristique inverse de celle de l'amplificateur de puissance, mais ce uniquement pour un modèle d'utilisation donné de cet amplificateur de puissance, et toute variation d'utilisation (i.e. variation de configuration d'utilisation) nécessite un réapprentissage du ou des réseaux de neurones utilisés. D'autre part, ces solutions nécessitent une quantité de données suffisante et un temps d'apprentissage associé qui ne sont pas adaptés à des systèmes de communication en temps réel.

L'invention a pour objet de remédier aux inconvénients de l'état de la technique en proposant une technique alternative de conception de module de prédistorsion numérique basée sur l'utilisation de réseaux de neurones, propre à réduire la quantité de donnée nécessaire à l'apprentissage et le temps d'apprentissage, tout en étant propre à s'adapter en temps réel à une variation d'utilisation de l'amplificateur de puissance considéré.

A cet effet, l'invention propose un dispositif de linéarisation, par prédistorsion numérique, d'un amplificateur de puissance d'un système de communication comprenant au moins un émetteur radiofréquence propre à transmettre au moins une trame de symboles, le dispositif de linéarisation comprenant :

- un module de prédistorsion numérique du signal fourni par l'émetteur radiofréquence configuré pour déterminer en inférence une prédistorsion dans le domaine polaire à appliquer audit signal, le module de prédistorsion, présentant une architecture d'apprentissage indirect par réseau de neurones, et comprenant :

  - un premier réseau de neurones configuré pour corriger une distorsion en amplitude produite par l'amplificateur de puissance en recevant en entrée l'amplitude de la sortie $|y|$ de l'amplificateur de puissance, le premier réseau de neurones étant propre à fournir une fonction réciproque $\widehat{f_\rho^{-1}}$ de la fonction de distorsion en amplitude produite par l'amplificateur de puissance ;
  - un deuxième réseau de neurones configuré pour corriger une distorsion en phase produite par l'amplificateur de puissance en recevant en entrée l'amplitude de l'entrée $|x|$ de l'amplificateur de puissance (20), le deuxième réseau de neurones (34) étant propre à fournir une fonction de phase $f_{\_\Phi}$ délivrant l'opposé en phase de chaque phase ;

le dispositif de linéarisation comprenant en outre :

- un module d'optimisation du premier réseau de neurones et d'optimisation du deuxième réseau de neurones configuré pour mettre en oeuvre :

  - un méta-apprentissage du premier réseau de neurones, et
  - un méta-apprentissage du deuxième réseau de neurones,

  le module d'optimisation étant configuré pour mettre en œuvre chaque méta-apprentissage à partir d'un ensemble de données de fonctionnement de l'amplificateur de puissance, chaque méta-apprentissage comprenant une pluralité de tâches de prédiction distinctes respectivement associées à des groupes de données de fonctionnement et de métadonnées distincts de l'ensemble de données, les groupes distincts étant représentatifs de cas distincts d'utilisation de l'amplificateur de puissance,
  le module d'optimisation étant configuré pour mettre en œuvre le méta-apprentissage du premier réseau de neurones, et le méta-apprentissage du deuxième réseau de neurones, en utilisant :

  - à partir d'une première partie dudit ensemble de données préalablement obtenue, une méta-initialisation du premier réseau de neurones, respectivement du deuxième réseau de neurones, fournissant au préalable une initialisation des poids initiaux du premier réseau de neurones, respectivement du deuxième réseau de neurones ;
  - à partir desdits poids initiaux et d'une deuxième partie dudit ensemble de données correspondant au cas d'utilisation courant de l'amplificateur de puissance, une méta-adaptation des poids initiaux en poids optimaux du premier réseau de neurones, respectivement du deuxième réseau de neurones ;

  le module d'optimisation étant propre à entrainer le premier réseau de neurones et le deuxième réseau de neurones en optimisant une fonction de coût.

Avantageusement, l'architecture du dispositif de linéarisation, par prédistorsion numérique, d'un amplificateur de puissance, proposée selon la présente invention, présente une complexité réduite, car spécifiquement basée sur une décomposition en deux réseaux de neurones dans le domaine polaire, l'un étant dédié à une correction sur mesure de la distorsion en amplitude propre à être générée par l'amplificateur de puissance considéré, et l'autre dédié à une correction sur mesure de la distorsion en phase. De plus, le module d'optimisation selon la présente invention, configuré pour mettre en œuvre un méta-apprentissage (de l'anglais *Meta-Learning*), est avantageusement propre à déterminer rapidement un dispositif de linéarisation par prédistorsion numérique, adapté à toute variation de fonctionnement de l'amplificateur de puissance considéré.

Autrement dit, selon la présente invention, le dispositif de linéarisation proposé présente un comportement adaptatif, car propre à adapter facilement la linéarisation en présence d'un changement de fonctionnement de l'amplificateur de puissance considéré ou en présence d'un changement de contexte d'utilisation, et la calibration de chacun des deux réseaux de neurones, dédiés respectivement à une correction des distorsions en amplitude et en phase introduites pas l'amplificateur de puissance considéré, est propre à être effectuée en temps réel (i.e. en ligne) avec un ensemble de données d'apprentissage réduit de même que la complexité de calcul associée par rapport aux solutions actuelles basées sur l'utilisation de réseaux de neurones.

Le dispositif de linéarisation, par prédistorsion numérique, d'un amplificateur de puissance proposée selon la présente invention peut également présenter une ou plusieurs des caractéristiques ci-dessous, prises indépendamment ou selon toutes les combinaisons techniquement envisageables :

- le premier réseau de neurones, configuré pour corriger une distorsion en amplitude produite par l'amplificateur de puissance, reçoit en entrée l'amplitude de la sortie $|y|$ de l'amplificateur de puissance, le premier réseau de neurones étant propre à fournir une fonction réciproque $\widehat{f_\rho^{-1}}$ de la fonction de distorsion en amplitude produite par l'amplificateur de puissance telle que :

$$\widehat{f_\rho^{-1}}(|y|) = g_0(|y|) + g_1(|y|)$$

avec :

$$g_0(|y|) = \gamma_0(|y|) + \big(1 - \gamma_0(|y|)\big)|y| \text{ où } \gamma_0(|y|) = (1 + e^{-\alpha(|y|-\omega_\rho)})^{-1},$$

et

$$g_1(|y|) = \sum_{j=1}^{N_n^\rho} \omega_j^\rho [ReLu(W_\rho\,|y| + b_\rho)]_j$$

où $\alpha,\ \omega_\rho,\ \omega_i^\rho \in \mathbb{R}, W_\rho \in \mathbb{R}^{1\times N_n^\rho}$ et $b_\rho \in \mathbb{R}^{1\times N_n^\rho}$ sont les poids du premier réseau de neurones dont la valeur initiale est optimisée par méta-apprentissage, *ReLu* est la fonction d'activation d'unité de rectification linéaire, et où $N_n^\rho$ correspond au nombre de neurones du premier réseau de neurones ;

- le deuxième réseau de neurones, configuré pour corriger une distorsion en phase produite par l'amplificateur de puissance, reçoit en entrée l'amplitude de l'entrée |x| de l'amplificateur de puissance, le deuxième réseau de neurones étant propre à fournir une fonction de phase $f_{-\phi}$ délivrant l'opposé en phase de chaque phase telle que :

$$f_{-\phi}(|x|) = \gamma_1(|x|)g_2(|x|)$$

avec :

$$\gamma_1(|x|) = (1 + e^{-\beta(|x|-\omega_\phi)})^{-1} \text{ et } g_2(|x|) = \sum_{j=1}^{N_n^\phi} \omega_j^\phi [ReLu(W_\phi\,|x| + b_\phi)]_j$$

où $\beta,\ \omega_\phi,\ \omega_j^\phi \in \mathbb{R}$, $W_\phi \in \mathbb{R}^{1\times N_n^\phi}$ et $b_\phi \in \mathbb{R}^{1\times N_n^\phi}$ sont les poids du deuxième réseau de neurones dont la valeur initiale est optimisée par méta-apprentissage, *ReLu* est la fonction d'activation d'unité de rectification linéaire, et où $N_n^\phi$ correspond au nombre de neurones du deuxième réseau de neurones ;

- chaque tâche de prédiction distincte est au moins associée à une valeur distincte caractérisant une variation de comportement de l'amplificateur de puissance ;
- le module d'optimisation est configuré pour mettre en œuvre un méta-apprentissage des poids du premier réseau de neurones, et/ou un méta-apprentissage des poids du deuxième réseau de neurones, en utilisant un méta-apprentissage agnostique au modèle de réseau(x) de neurones utilisé(s) ;
- le module d'optimisation est propre à entrainer le premier réseau de neurones et le deuxième réseau de neurones en optimisant une fonction de coût correspondant à l'erreur quadratique moyenne au moyen d'un optimiseur ADAM ou RADAM ;
- un module d'acquisition de données configuré pour alimenter chaque groupe de données de fonctionnement et de métadonnées distincts de l'ensemble de données de l'amplificateur de puissance en prélevant en sortie de l'émetteur radiofréquence un nombre prédéterminé de symboles, l'ensemble des symboles prélevés étant conforme à une distribution statistique en amplitude prédéterminée dudit nombre prédéterminé de symboles.

L'invention concerne également un système de communication comprenant au moins successivement :

- un modulateur radiofréquence ;
- un émetteur radiofréquence propre à transmettre au moins une trame de symboles dont l'entrée est connectée à la sortie du modulateur de fréquence ;
- un dispositif de linéarisation par prédistorsion numérique selon l'une quelconque des revendications précédentes, l'entrée du dispositif de linéarisation étant connectée à la sortie dudit émetteur radiofréquence ; et
- un amplificateur de puissance dont l'entrée est connectée à la sortie du dispositif de linéarisation,

le système de communication comprenant une boucle de rétroaction de l'amplificateur de puissance vers le dispositif de linéarisation.

L'invention concerne également un procédé de linéarisation, par prédistorsion numérique adaptative, d'un amplificateur de puissance d'un système de communication comprenant un émetteur radiofréquence propre à transmettre au moins une trame de symboles, le procédé comprenant les étapes suivantes :

- une étape de prédistorsion numérique du signal fourni par l'émetteur radiofréquence en déterminant une prédistorsion polaire à appliquer audit signal par mise en œuvre d'une étape d'inférence par :

  - un premier réseau de neurones configuré pour corriger une distorsion en amplitude associée à l'amplificateur de puissance ; et
  - un deuxième réseau de neurones configuré pour corriger une distorsion en phase associée à l'amplificateur de puissance,

- une étape d'optimisation du premier réseau de neurones et d'optimisation du deuxième réseau de neurones par :

  - méta-apprentissage du premier réseau de neurones, et
  - méta-apprentissage du deuxième réseau de neurones,

  chaque méta-apprentissage étant mis en œuvre à partir d'un ensemble de données de fonctionnement de l'amplificateur de puissance, chaque méta-apprentissage comprenant une pluralité de tâches de prédiction distinctes respectivement associées à des groupes de données de fonctionnement et de métadonnées distincts de l'ensemble de données, les groupes distincts étant représentatifs de cas distincts d'utilisation de l'amplificateur de puissance, le méta-apprentissage du premier réseau de neurones, et le méta-apprentissage du deuxième réseau de neurones, comprenant :

  - à partir d'une première partie dudit ensemble de données préalablement obtenue, une méta-initialisation du premier réseau de neurones, respectivement du deuxième réseau de neurones, fournissant au préalable une initialisation des poids initiaux du premier réseau de neurones, respectivement du deuxième réseau de neurones ;
  - à partir desdits poids initiaux et d'une deuxième partie dudit ensemble de données correspondant au cas d'utilisation courant de l'amplificateur de puissance, une méta-adaptation des poids initiaux en poids optimaux du premier réseau de neurones, respectivement du deuxième réseau de neurones.

L'invention a également pour objet un programme d'ordinateur comportant des instructions logicielles qui, lorsqu'elles sont exécutées par un ordinateur, mettent en œuvre un procédé de linéarisation, par prédistorsion numérique adaptative, d'un amplificateur de puissance d'un système de communication tel que défini ci-dessus.

Par la suite, la référence à un programme d'ordinateur qui, lorsqu'il est exécuté, effectue l'une quelconque des instructions logicielles précitées, ne se limite pas à un programme d'application s'exécutant sur un ordinateur hôte unique.

En d'autres termes, les termes programme d'ordinateur et logiciel sont utilisés par la suite dans un sens général pour faire référence à tout type de code informatique (par exemple, un logiciel d'application, un micro logiciel, un microcode, ou toute autre forme d'instruction d'ordinateur) qui peut être utilisé pour programmer un ou plusieurs processeurs pour mettre en œuvre le procédé de linéarisation, par prédistorsion numérique adaptative, d'un amplificateur de puissance d'un système de communication tel que défini ci-dessus.

D'autres caractéristiques et avantages de l'invention ressortiront de la description qui en est donnée ci-dessous, à titre indicatif et nullement limitatif, en référence aux figures annexées, parmi lesquelles :

[Fig 1] la figure 1 représente schématiquement un système de communication selon la présente invention ;
[Fig 2] la figure 2 représente schématiquement la structure d'un dispositif de linéarisation, par prédistorsion numérique, d'un amplificateur de puissance du système de communication selon la figure 1 ;
[Fig 3] la figure 3 illustre le méta-apprentissage mis en œuvre par le module d'optimisation du dispositif de linéarisation, par prédistorsion numérique selon la présente invention ;
[Fig 4] la figure 4 illustre le fonctionnement du module d'acquisition de données optionnel du dispositif de linéarisation, par prédistorsion numérique selon la présente invention.

Dans la suite de la description, le terme « sensiblement » est utilisé pour exprimer une relation d'égalité à plus ou moins 10%, c'est-à-dire avec une variation d'au plus 10%, de préférence encore comme une relation d'égalité à plus ou moins 5%, c'est-à-dire avec une variation d'au plus 5%.

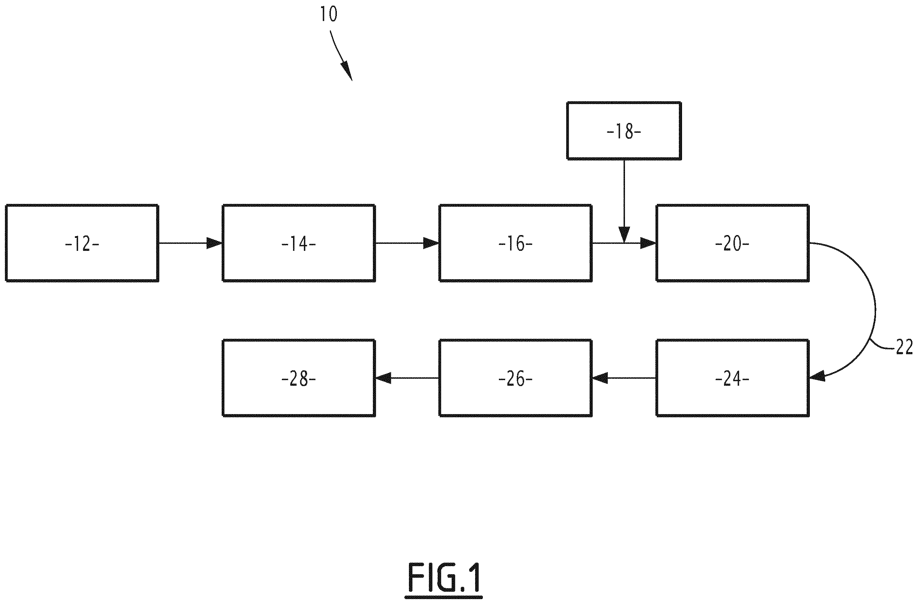

La figure 1 représente schématiquement l'architecture générale d'un système de communication 10 selon la présente invention. Plus précisément, le système de communication 10 reçoit en entrée d'une chaine de transmission un flux 12 de données, notamment exprimées sous forme de bits de données.

La chaine de transmission du système de communication 10 comprend tout d'abord un modulateur radiofréquence 14 configuré pour moduler le flux de données 12, notamment en amplitude et en phase en utilisant par exemple une modulation d'amplitude en quadrature QAM (de l'anglais *quadrature amplitude modulation*) ou encore une modulation par changement de phase PSK (de l'anglais *phase-shift keying*), etc.

Puis, en sortie du modulateur radiofréquence 14, la chaine de transmission comprend un émetteur 16 radiofréquence propre à transmettre au moins une trame de symboles obtenus à partir du signal modulé fourni en sortie par le modulateur radiofréquence 14. Par exemple, l'émetteur radiofréquence 16 est un générateur de forme d'onde multiporteuses orthogonales émetteur de symboles OFDM (de l'anglais *Orthogonal Frequency Division Multiplexing*), un générateur de forme d'onde de troisième génération à accès multiple par répartition en code 3G CDMA (de l'anglais *Code Division Multiple Access*), un générateur de forme d'onde à porteuse unique, un générateur de faisceau hertzien, etc.

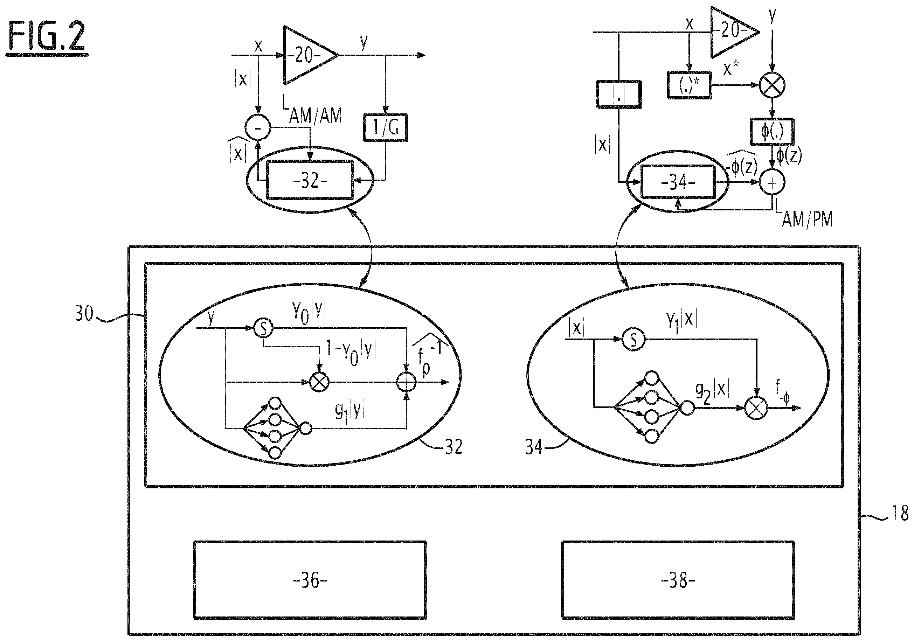

Tel que proposé selon la présente invention, le système de communication 10 comprend en outre un dispositif 18 de linéarisation, par prédistorsion numérique DPD (de l'anglais *digital predistorsion*), dont la structure spécifique est détaillée par la suite en relation avec la figure 2. Un tel dispositif 18 de linéarisation, par prédistorsion numérique DPD est propre à compenser les distorsions introduites par un amplificateur de puissance 20 lui-même placé en amont d'au moins une antenne de transmission, non représentée, de la chaine de transmission du système de communication.

Autrement dit, l'entrée du dispositif 18 de linéarisation, par prédistorsion numérique DPD est connectée à la sortie de l'émetteur radiofréquence 16, et sa sortie est localisée en amont de l'amplificateur de puissance 20, de sorte que le signal, fourni en sortie de la combinaison de ce dispositif 18 de linéarisation, par prédistorsion numérique DPD suivi de l'amplificateur de puissance 20, est sensiblement linéaire.

Le système de communication 10 comprend en outre une chaine de réception comprenant un récepteur radiofréquence 24 associé de manière réciproque à l'émetteur radiofréquence 16 de la chaine de transmission. Autrement dit, en cas de mise en oeuvre d'un émetteur OFDM 16 dans la chaine de transmission, la chaine de réception comprend réciproquement un récepteur OFDM, de même en cas de mise en oeuvre d'un émetteur CDMA 16 dans la chaine de transmission, la chaine de réception comprend réciproquement un récepteur CDMA, etc.

De la même manière, la chaine de réception comprend un démodulateur 26 associé de manière réciproque au modulateur 14 de la chaine de transmission, par exemple un démodulateur QAM lorsqu'un modulateur QAM est utilisé au sein de la chaine de transmission, le démodulateur étant configuré pour fournir un signal démodulé 28 correspondant sensiblement au flux de données 12.

L'amplificateur de puissance 20 dont la linéarisation est l'objet de la présente invention, présente une entrée notée $x$ et une sortie notée $y$, et est propre à générer une distorsion en amplitude, exprimée par exemple au moyen d'une fonction de distorsion $f_p$, et une distorsion en phase, exprimée par exemple au moyen d'une fonction de distorsion $f_\phi$, telles que :

$$|y| = f_p(|x|) \qquad (1)$$

$$\arg(y) = f_\phi(|x|) + \arg(x) \qquad (2).$$

Par exemple, en considérant la modélisation mathématique et théorique de Rapp, notamment pour des fréquences supérieures à 6GHz les deux fonctions de distorsion $f_p$ et $f_\phi$ sont exprimables sous la forme suivante :

$$f_p(u) = \frac{Gu}{\left(1 + \left|\frac{Gu}{V_{sat}}\right|^{2p}\right)^{\frac{1}{2p}}} \qquad (3)$$

$$f_\phi(u) = \frac{Au^q}{\left(1 + \left(\frac{u}{A'}\right)^q\right)} \qquad (4)$$

où G est le gain dans la zone linéaire de l'amplificateur 20 de puissance, p le facteur de transition (de l'anglais *knee factor*) du modèle de Rapp et $V_{sat}$ la valeur de tension de saturation de l'amplificateur de puissance 20, *A, A'* et q des paramètres d'ajustement, en considérant un recul d'entrée IBO (de l'anglais *Input Back-Off*) sous la forme suivante :

$$IBO = \frac{P_{1dB,in}}{P_{a,in}}$$

avec $P_{1dB,in}$ la puissance d'entrée au point de compression à 1dB et $P_{a,in}$ la puissance moyenne d'entrée, et ce en considérant par ailleurs un amplificateur de puissance 20 exempt de bruit.

La figure 2 représente schématiquement la structure spécifique selon la présente invention du dispositif 18 de linéarisation par prédistorsion numérique de l'amplificateur de puissance 20 du système de communication 10 selon la figure 1.

La structure spécifique du dispositif 18 de linéarisation par prédistorsion numérique selon la présente invention est basée sur une architecture d'apprentissage indirect ILA (de l'anglais « *Indirect Learning* ») par réseau de neurones et comprend pour ce faire tout d'abord un module 30 de prédistorsion numérique du signal fourni par l'émetteur radiofréquence 16 de la figure 1.

Un tel module 30 de prédistorsion numérique basé sur une architecture d'apprentissage indirect par réseau de neurones est configuré pour déterminer en inférence une prédistorsion dans le domaine polaire à appliquer au signal fourni par l'émetteur radiofréquence 16, le module de prédistorsion 30 comprenant :

- un premier réseau de neurones 32 configuré pour corriger une distorsion en amplitude produite par l'amplificateur de puissance 20 en recevant en entrée l'amplitude de la sortie $|y|$ de l'amplificateur de puissance 20, le premier réseau de neurones 32 étant propre à fournir une fonction réciproque $\widehat{f_\rho^{-1}}$ de la fonction de distorsion en amplitude produite par l'amplificateur de puissance ;
- un deuxième réseau de neurones 34 configuré pour corriger une distorsion en phase produite par l'amplificateur de puissance 20 en recevant en entrée l'amplitude de l'entrée $|x|$ de l'amplificateur de puissance 20, le deuxième réseau de neurones 34 étant propre à fournir une fonction de phase $f_{\_\Phi}$ délivrant l'opposé en phase de chaque phase.

Autrement dit, l'architecture d'apprentissage indirect par réseau de neurones proposée selon la présente invention pour mettre en œuvre une linéarisation par prédistorsion numérique d'un amplificateur de puissance 20 est caractéristique en ce qu'elle est spécifiquement conçue pour traiter séparément les distorsions d'amplitude et de phase introduites par l'amplificateur de puissance 20 localisé en aval du dispositif 18 de linéarisation par prédistorsion numérique, et ce en utilisant une décomposition polaire du signal.

Une telle conception d'apprentissage indirect basé par ailleurs sur une décomposition polaire permet d'améliorer les performances de linéarisation, notamment en comparaison des techniques classiques d'apprentissage direct.

La décomposition polaire mise en œuvre par la présente invention se traduit par l'utilisation de deux réseaux de neurones distincts 32 et 34 dédiés respectivement à la correction d'une distorsion en amplitude produite par l'amplificateur de puissance 20 pour le premier réseau de neurones 32, et d'une distorsion en phase produite par l'amplificateur de puissance 20 pour le deuxième réseau de neurones 34, et présentant chacun une faible complexité d'implémentation.

En particulier, pour inverser la distorsion en amplitude produite par l'amplificateur de puissance 20, le premier réseau de neurones 32 est conçu sur mesure (i.e. entièrement spécifique à la présente invention) pour déterminer la fonction réciproque $\widehat{f_\rho^{-1}}$ de la fonction de distorsion en amplitude $f_p$ produite par l'amplificateur de puissance 20 telle qu'indiquée précédemment (équation (1)), et reçoit en entrée l'amplitude de la sortie $|y|$ de l'amplificateur de puissance 20, le cas échéant normalisée en gain par application d'un facteur $1/G$ avec $G$ le gain, tel qu'illustré sur la figure 2.

Plus précisément, le premier réseau de neurones 32 est optimisé de sorte que la composée de la fonction de distorsion en amplitude $f_p$ et de la fonction réciproque de cette distorsion en amplitude $\widehat{f_\rho^{-1}}$ soit égale au gain du signal $|x|$ auquel une telle composée est appliquée, la fonction réciproque $\widehat{f_\rho^{-1}}$ présentant un gain unitaire, une normalisation par $1/G$ étant mise en œuvre uniquement en phase d'entrainement :

$$(f_p \circ \widehat{f_\rho^{-1}})(|x|) = G|x| \qquad (6)$$

$$\widehat{f_\rho^{-1}}(|y|) = g_0(|y|) + g_1(|y|) = \widehat{|x|}$$

avec :

$$g_0(|y|) = \gamma_0(|y|) + \big(1 - \gamma_0(|y|)\big)|y| \text{ où } \gamma_0(|y|) = (1 + e^{-\alpha(|y|-\omega_\rho)})^{-1},$$

et

$$g_1(|y|) = \sum_{j=1}^{N_n^\rho} \omega_j^\rho \big[ReLu(W_\rho \, |y| + b_\rho)\big]_j$$

où $\alpha$, $\omega_\rho$, $\omega_j^\rho \in \mathbb{R}$, $W_\rho \in \mathbb{R}^{1 \times N_n^\rho}$ et $b_\rho \in \mathbb{R}^{1 \times N_n^\rho}$ sont les poids du premier réseau de neurones dont la valeur initiale est optimisée par méta-apprentissage, *ReLu* est la fonction d'activation d'unité de rectification linéaire notamment définie tel que $f(U_i) = \max(0, U_i)$, avec $U_i = [U]_i$ où l'indice i correspond au i$^{\text{ème}}$ élément du vecteur U, et où $N_n^\rho$ correspond au nombre de neurones du premier réseau de neurones 32, par exemple avantageusement selon la présente invention $N_n^\rho$ est sensiblement compris entre huit et dix neurones pour la correction de l'amplitude.

Par la suite, on entend par « méta-apprentissage » le concept d'apprentissage de réseau de neurones introduit notamment récemment dans le domaine des communications sans fil tel que décrit dans le document de O. Simeone et al. intitulé « *From Learning to Meta-Learning : Reduced Training Overhead and Complexity for Communication Systems* ». Toutefois, ce concept d'apprentissage n'a jusqu'ici pas été spécifiquement appliqué et adapté à la conception d'un dispositif 18 adaptatif de linéarisation, par prédistorsion numérique d'un amplificateur de puissance.

Plus précisément, la fonction $g_0$ permet de modéliser la fonction réciproque de la fonction de distorsion en amplitude $f_p$ produite par l'amplificateur de puissance 20 tandis que la fonction $g_1$ permet de l'affiner (i.e. de la raffiner).

De plus, tel qu'illustré sur la figure 2, le premier réseau de neurones 32 est propre à recevoir également l'entrée $L_{AM/AM}$ telle que par exemple :

$$L_{AM/AM} = \frac{1}{N} \sum_{i=1}^{N} \big\| |x_i| - \widehat{|x_i|} \big\|^2$$

avec N la taille du jeu de données dédié à l'entrainement, l'entrée $L_{AM/AM}$ correspond à une fonction de coût correspondant à l'erreur quadratique moyenne entre l'amplitude du signal d'entrée *x* de l'amplificateur de puissance 20 (i.e. correspondant à l'amplitude du signal de sortie de l'émetteur radiofréquence 16) et l'estimation de cette amplitude d'entrée fournie par le premier réseau de neurones 32, cette fonction de coût étant propre à être utilisée par un module d'optimisation 36 du dispositif 18 de linéarisation par prédistorsion numérique, tel que décrit par la suite.

Par ailleurs, pour inverser la distorsion en phase produite par l'amplificateur de puissance 20, le deuxième réseau de neurones 34 est conçu sur mesure pour déterminer la fonction opposée en phase $f_{-\phi}$ (i.e. délivrant l'opposé en phase de chaque phase) de la fonction de distorsion en phase $f_\phi$ produite par l'amplificateur de puissance 20 telle qu'indiquée précédemment (équation (2)), et reçoit en entrée l'amplitude de l'entrée |x| de l'amplificateur de puissance 20, tel qu'illustré sur la figure 2.

Plus précisément, le deuxième réseau de neurones 34 est optimisé de sorte que la somme des fonctions de distorsion en phase $f_\phi$ et son opposée $f_{-\phi}$ soit égale à zéro :

$$f_\phi(|x|) + f_{-\phi}(|x|) = 0 \qquad\qquad (7)$$

où

$$f_{-\phi}(|x|) = \gamma_1(|x|)g_2(|x|)$$

avec :

$$\gamma_1(|x|) = (1 + e^{-\beta(|x|-\omega_\Phi)})^{-1} \text{ et } g_2(|x|) = \sum_{j=1}^{N_n^\Phi} \omega_j^\Phi [ReLu(W_\Phi |x| + b_\Phi)]_j$$

où $\beta$, $\omega_\Phi$, $\omega_j^\Phi \in \mathbb{R}$, $W_\Phi \in \mathbb{R}^{1 \times N_n^\Phi}$ et $b_\Phi \in \mathbb{R}^{1 \times N_n^\Phi}$ sont les poids du deuxième réseau de neurones dont la valeur initiale est optimisée par méta-apprentissage, *ReLu* est la fonction d'activation d'unité de rectification linéaire, et où $N_n^\Phi$ correspond au nombre de neurones du deuxième réseau de neurones 34, par exemple avantageusement selon la présente invention $N_n^\Phi$ est sensiblement compris entre quatre et six neurones pour la correction de la phase, si bien que le nombre total de neurones mis en œuvre en utilisant les deux réseaux de neurones 32 et 34 respectivement dédiés à la correction de l'amplitude et de la phase est compris entre douze et seize neurones, la configuration à douze neurones offrant des résultats performants par simulation numérique.

De manière similaire au premier réseau de neurones 32, tel qu'illustré sur la figure 2, le deuxième réseau de neurones 34 est propre à recevoir également l'entrée $L_{AM/PM}$ telle que par exemple

$$L_{AM/PM} = \frac{1}{N} \sum_{i=1}^N \left\| \Phi(z) + (-\widehat{\Phi(z)}) \right\|^2$$

, l'entrée $L_{AM/PM}$ correspond à une fonction de coût correspondant à l'erreur quadratique moyenne entre la phase du signal fourni par l'amplificateur de puissance 20 (i.e. correspondant à l'amplitude du signal de sortie de l'émetteur radiofréquence 16), la phase $\Phi$ résultant du conjugué (.)* du signal d'entrée *x* en considérant :

$$z = x * y \qquad (8)$$

$$z = |x|.|y|e^{i(\arg(y)-\arg(x))}$$

$$\arg(z) = f_\Phi(|x|)$$

Cette fonction de coût $L_{AM/PM}$ est propre à être utilisée par un module d'optimisation 36 du dispositif 18 de linéarisation par prédistorsion numérique, tel que décrit par la suite.

En effet, outre le module 30 de prédistorsion numérique précédemment décrit, le dispositif 18 de linéarisation par prédistorsion numérique selon la présente invention comprend également un module d'optimisation 36 du premier réseau de neurones 32 et d'optimisation du deuxième réseau de neurones 34, en étant configuré pour mettre en œuvre :

- un méta-apprentissage du premier réseau de neurones 32, et
- un méta-apprentissage du deuxième réseau de neurones 34.

En particulier, le module d'optimisation 36 est configuré pour mettre en œuvre chaque méta-apprentissage à partir d'un ensemble de données de fonctionnement de l'amplificateur de puissance, chaque méta-apprentissage comprenant une pluralité de « tâches de prédiction » distinctes respectivement associées à des groupes de données de fonctionnement et de métadonnées distincts de l'ensemble de données, les groupes de données distincts étant représentatifs de cas distincts d'utilisation de l'amplificateur de puissance,

le module d'optimisation 36 étant configuré pour mettre en œuvre le méta-apprentissage du premier réseau de neurones 32, et le méta-apprentissage du deuxième réseau de neurones 34, en utilisant :

- à partir d'une première partie dudit ensemble de données préalablement obtenue, une méta-initialisation du premier réseau de neurones, respectivement du deuxième réseau de neurones, fournissant au préalable une initialisation des poids initiaux du premier réseau de neurones, respectivement du deuxième réseau de neurones ;
- à partir desdits poids initiaux et d'une deuxième partie dudit ensemble de données correspondant au cas d'utilisation courant de l'amplificateur de puissance, une méta-adaptation des poids initiaux en poids optimaux du premier réseau de neurones, respectivement du deuxième réseau de neurones ;

le module d'optimisation 36 étant propre à entrainer le premier réseau de neurones 32 et le deuxième réseau de neurones 34 en optimisant une fonction de coût.

En particulier, le module d'optimisation 36 est propre à entrainer le premier réseau de neurones 32 et le deuxième réseau de neurones 34 en utilisant un algorithme d'apprentissage indirect ILA et en optimisant une fonction de coût correspondant à l'erreur quadratique moyenne :

- $L_{AM/AM}$ pour le premier réseau de neurones 32 dédié à la correction de la distorsion en amplitude introduite par l'amplificateur de puissance 20, et
- $L_{AM/PM}$ pour le deuxième réseau de neurones 34 dédié à la correction de la distorsion en phase introduite par l'amplificateur de puissance 20 ;

et ce, selon un premier exemple, en utilisant un optimiseur ADAM tel que décrit dans le document de P.K. Diederik et al. intitulé « *ADAM : a Method for stochastic Optimization »,* ou encore un optimiseur RADAM (de l'anglais *Rectified ADAM,* ADAM pour *Adaptative Momentum estimation*) tel que décrit dans le document de L. Liu et al. intitulé « *On the Variance of the Adaptative Learning Rate and Beyond* » permettant d'améliorer la convergence de la solution, et en utilisant une descente de gradient pour mettre à jour les paramètres de chaque réseau de neurones 32 et 34 du module de prédistorsion numérique 30.

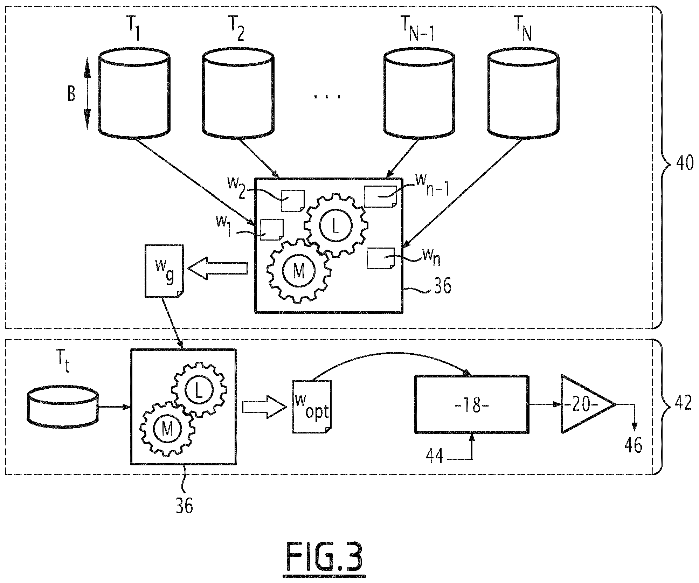

Le fonctionnement du module d'optimisation 36 sera davantage détaillé en relation avec la figure 3 détaillée ci-après relative à un deuxième exemple de mise en œuvre.

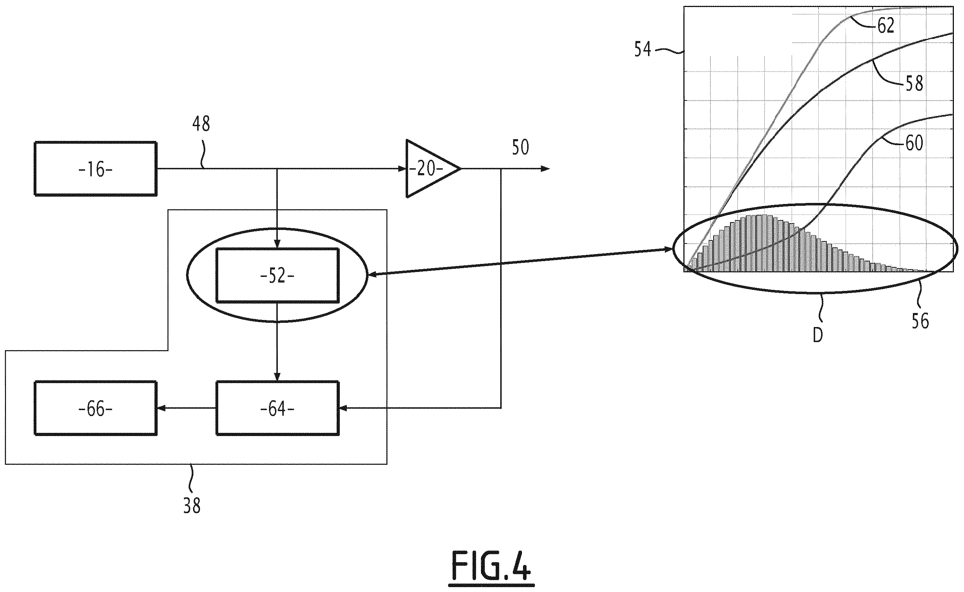

Selon un autre aspect particulier complémentaire et optionnel, détaillé par la suite en relation avec la figure 4, le dispositif 18 de linéarisation par prédistorsion numérique selon la présente invention comprend également un module 38 d'acquisition de données configuré pour alimenter chaque groupe de données de fonctionnement et de métadonnées distinct de l'ensemble de données de l'amplificateur de puissance 20 en prélevant en sortie de l'émetteur radiofréquence 16 un nombre prédéterminé de symboles, l'ensemble des symboles prélevés étant conforme à une distribution statistique en amplitude prédéterminée dudit nombre prédéterminé de symboles.

L'utilisation d'un tel module 38 d'acquisition vise à optimiser la quantité de données d'apprentissage utilisée notamment pour une phase en ligne de calibration.

En relation avec la figure 3, on décrit ci-après plus en détail le fonctionnement du module d'optimisation 36 qui vise principalement à rendre adaptatif le dispositif 18 de linéarisation, par prédistorsion numérique selon la présente invention afin d'adapter facilement, et notamment quasiment en temps réel, voire directement en temps réel, la linéarisation en présence d'un changement de fonctionnement de l'amplificateur de puissance considéré ou en présence d'un changement de contexte d'utilisation, ce qui est actuellement peu aisé avec les techniques de linéarisation actuelles qui ne fournissent un résultat optimal que pour un cas (i.e. une configuration) d'utilisation particulier, et nécessitent un lourd réapprentissage en temps, données d'apprentissage et en ressources pour réoptimiser le ou les réseaux de neurones associé à la prédistorsion numérique d'un amplificateur de puissance, en cas de changement de fonctionnement de l'amplificateur de puissance considéré ou en présence d'un changement de contexte d'utilisation.

Pour ce faire, comme illustré sur la figure 3, et tel qu'indiqué précédemment, le module d'optimisation 36 est configuré pour mettre en œuvre chaque méta-apprentissage à partir d'un ensemble de données de fonctionnement de l'amplificateur de puissance, chaque méta-apprentissage comprenant une pluralité de tâches de prédiction distinctes $T_1, T_2, ... T_{N-1}$ et $T_N$ respectivement associées à des groupes de données de fonctionnement et de métadonnées distincts de l'ensemble de données, les groupes distincts étant représentatifs de cas distincts d'utilisation de l'amplificateur de puissance.

En particulier, sur la figure 3 chaque tâche de prédiction $T_1, T_2, ...T_{N-1}$ et $T_N$ est notamment associée à B symboles OFDM distincts par exemple, lorsque l'émetteur radiofréquence est par exemple un émetteur OFDM, avec B un nombre entier de symboles OFDM associés à une valeur distincte, d'une tâche de prédiction à une autre, caractérisant une variation de comportement de l'amplificateur de puissance 20, une telle variation étant par exemple associée à une température d'utilisation particulière, un courant et/ou une tension d'alimentation propre(s), une adaptation de l'antenne d'émission, une pression d'utilisation, ou une combinaison d'au moins deux de ces facteurs, variation se traduisant alors théoriquement par une variation du facteur p de transition (de l'anglais *knee factor)* du modèle théorique de Rapp tel qu'exprimé précédemment à l'aide de l'équation (3).

Le méta-apprentissage mis en oeuvre spécifiquement par le module d'optimisation 36 vise à « apprendre à apprendre » (de l'anglais *learn to learn*) à chacun des réseaux de neurones 32 et 34, précédemment décrits et dédiés respectivement à la linéarisation en amplitude et en phase de l'amplificateur de puissance 20, à s'adapter en cas de changement de fonctionnement de l'amplificateur de puissance considéré ou en présence d'un changement de contexte d'utilisation, et ce à l'aide d'un apprentissage utilisant la pluralité de tâches distinctes (configuration d'utilisation) précédemment décrites, alors que les techniques d'apprentissage conventionnelles basées sur une optimisation « mono-cas » ou « mono-contexte d'utilisation » sont actuellement impropres à fournir simplement et rapidement une telle adaptation, ce qui entraine une consommation d'énergie inadaptée.

A l'inverse, selon la présente invention, notamment pendant une étape 40 d'apprentissage hors ligne, le module d'optimisation 36 est propre à « apprendre à apprendre » par méta-apprentissage, à chacun des réseaux de neurones 32 et 34, les poids spécifiques associés respectivement à chaque tâche de prédiction (i.e. à chaque fonctionnement et/ou contexte d'utilisation de l'amplificateur de puissance, encore également appelée configuration d'utilisation de l'amplificateur de puissance 20).

Par exemple, les poids spécifiques $w_1$ sont appris pour la tâche de prédiction $T_1$, les poids spécifiques $w_2$ sont appris pour la tâche de prédiction $T_2$, ... , puis les poids spécifiques $w_{n-1}$ sont appris pour la tâche de prédiction $T_{N-1}$, et enfin les poids spécifiques $w_N$ sont appris pour la tâche de prédiction $T_N$, poids spécifiques que le module d'optimisation 36 transforme (i.e. généralise) en un seul ensemble de poids génériques $w_g$ d'initialisation conformément au concept de méta-apprentissage.

De tels poids génériques $w_g$ d'initialisation sont ensuite directement utilisés, notamment lors d'une étape 42 d'adaptation en ligne, pour être adaptés en poids optimaux $w_{opt}$ au cas d'utilisation courant de l'amplificateur de puissance 20 associé cette fois à la tache de prédiction $T_t$ à l'instant t pour application à un signal radiofréquence 44 par le dispositif 18 de linéarisation par prédistorsion numérique, préalablement à l'action de l'amplificateur de puissance 20 pour générer un signal 46 amplifié en puissance.

Autrement dit, le méta-apprentissage mis en œuvre spécifiquement selon la présente invention pour configurer un dispositif 18 de linéarisation par prédistorsion numérique d'amplificateur de puissance 20 permet de partir d'un ensemble de poids génériques $w_g$ initiaux obtenus au cours d'un apprentissage multi-configurations d'utilisation de l'amplificateur de puissance 20, et mis en œuvre avantageusement hors ligne (i.e. de l'anglais *offline*), pour être adapté ensuite, en ligne (i.e. de l'anglais *online*), en un ensemble de poids optimaux $w_{opt}$ aux seules données associées à la configuration d'utilisation courante de l'amplificateur de puissance 20, ce qui permet une adaptation rapide à partir d'un ensemble $T_t$ de données limitées, contrairement aux techniques de linéarisation actuelles, à base de réseau(x) de neurones, optimales pour une unique configuration d'utilisation et impropres à s'adapter rapidement à un changement de configuration.

Selon un aspect particulier optionnel, le module d'optimisation 36 est configuré pour mettre en œuvre, selon un deuxième exemple, un méta-apprentissage des poids du premier réseau de neurones 32, et/ou un méta-apprentissage des poids du deuxième réseau de neurones 34, en utilisant un méta-apprentissage agnostique au modèle de réseau(x) de neurones utilisé(s) MAML (de l'anglais *Model-Agnostic Meta-Learning*) propre à permettre une généralisation et une adaptation rapide des réseaux de neurones et tel qu'introduit par C. Finn et al. dans le document intitulé « *Model-Agnostic Meta-Learning for Fast Adaptation of deep Networks »*.

Un tel méta-apprentissage MAML a pour but de déterminer les meilleurs poids d'initialisation de chaque réseau de neurones 32 et 34 utilisés pour une inférence ultérieure sur l'ensemble de donnée $T_t$. Compte-tenu de cet objectif un tel méta-apprentissage fournit un initialiseur optimisé, alors que dans l'apprentissage conventionnel les poids de réseau(x) de neurones sont généralement initialisés aléatoirement, ce qui est propre à ralentir la convergence et à conduire à une mauvaise généralisation.

En appliquant le méta-apprentissage MAML à la représentation de la figure 3, un tel méta-apprentissage MAML est propre à comprendre deux étapes principales correspondant d'une part à l'étape 40 d'apprentissage, notamment hors ligne, permettant la détermination des meilleurs poids initiaux $w_g$ de chacun des réseaux de neurones 32 et 34, et d'autre part à l'étape 42 d'adaptation, notamment en ligne, permettant de converger vers les poids $w_{opt}$ adaptés au cas d'utilisation courant.

Autrement dit, selon la présente invention, le module d'optimisation 36 est configuré pour mettre en œuvre le méta-apprentissage du premier réseau de neurones 32, et le méta-apprentissage du deuxième réseau de neurones 34, en utilisant :

-   à partir d'une première partie dudit ensemble de données préalablement obtenue, une méta-initialisation 40 du premier réseau de neurones, respectivement du deuxième réseau de neurones, fournissant au préalable une initialisation des poids initiaux du premier réseau de neurones, respectivement du deuxième réseau de neurones ;
-   à partir desdits poids initiaux et d'une deuxième partie dudit ensemble de données correspondant au cas d'utilisation courant de l'amplificateur de puissance, une méta-adaptation 42 des poids initiaux en poids optimaux du premier réseau de neurones, respectivement du deuxième réseau de neurones.

Plus précisément, en prenant en exemple le cas particulier d'utilisation d'un méta-apprentissage MAML, chaque tâche de prédiction est caractérisée par deux sous-ensembles de données distincts, à savoir un sous-ensemble $D_i^{tr}$ de données d'entrainement (i.e. d'apprentissage), et un sous-ensemble $D_i^{te}$ de données test, chaque tâche de prédiction $T_i$, avec $1 \leq i \leq N$, comme indiqué précédemment, étant associée à une variation de comportement de l'amplificateur de puissance 20 qui lui est propre, une telle variation étant par exemple associée à une température d'utilisation particulière, un courant et/ou une tension d'alimentation propre(s), une adaptation de l'antenne d'émission, une pression d'utilisation, ou une combinaison d'au moins deux de ces facteurs, variation se traduisant alors théoriquement par une variation du facteur p de transition (de l'anglais *knee factor*) du modèle théorique de Rapp tel qu'exprimé précédemment à l'aide de l'équation (3).

A titre d'exemple explicatif, pour déterminer les solutions de l'équation y = *C* sin *x* + *φ* où *C* et *φ* correspondent respectivement à l'amplitude et à la phase, en utilisant un méta-apprentissage MAML, il est possible d'apprendre à partir de tâches de prédiction multiples $T_i$, paramétrées par des valeurs distinctes de C et *φ*, chaque tâche de prédiction $T_i$, consistant à retrouver y à partir de *x* avec différentes amplitudes et différentes phases.

Plus précisément, en utilisant le méta-apprentissage MAML, pour chaque tâche de prédiction $T_i$, les poids spécifiques $w_i$, par exemple les poids spécifiques $w_1$ pour la tâche de prédiction $T_1$, sont appris en utilisant une descente de gradient, une étape de descente de gradient étant telle que :

$$w_i = w_g - \varepsilon \nabla_{w_g} L\left(w_g, D_i^{tr}\right) \qquad (9)$$

où $\varepsilon$ est un taux d'apprentissage interne permettant de contrôler la descente de gradient afin de minimiser la fonction de coût L correspondant à l'une des fonctions de coût $L_{AM/AM}$ ou $L_{AM/PM}$ précitées, l'opérateur $\nabla_{w_g}$ indiquant que les gradients de la fonction L considérée sont évalués par rapport aux poids initiaux $w_g$, cette première étape de descente de gradient étant classiquement appelée « méta-mise à jour » ou encore « boucle interne » et mise en œuvre pour chaque tâche de prédiction $T_i$. Ensuite les poids génériques $w_g$ sont déterminés en utilisant le méta-apprentissage MAML en résolvant le problème d'optimisation suivant :

$$\min_{w_g} \sum_i L\left(w_i, D_i^{te}\right) \qquad (10)$$

et ce au moyen d'une descente de gradient conduisant à :

$$w_g = w_g - \mu \nabla_{w_g} \sum_i L\left(w_i, D_i^{te}\right) \qquad (11)$$

où $\mu$ est un taux d'apprentissage externe, cette deuxième étape de descente de gradient étant classiquement appelée « méta-optimisation » ou encore « boucle externe ».

Les méta-mises à jour MAML propres à chaque tâche de prédiction $T_i$ puis la méta-optimisation MAML forment une méta-initialisation MAML 40, notamment hors ligne, des poids initiaux $w_g$ du premier réseau de neurones 32 et du deuxième réseau de neurones 34 respectivement.

Autrement dit, selon ce deuxième exemple, le méta-apprentissage MAML appliqué à l'invention permet premièrement d'optimiser chacune des fonctions de coût $L_{AM/AM}$ ou $L_{AM/PM}$ précitées avec un nombre réduit d'itérations, puis on minimise la somme des fonctions de coût $L_{AM/AM}$ et $L_{AM/PM}$ optimisées pour dériver les poids initiaux $w_g$. Une telle minimisation de la somme conformément au méta-apprentissage MAML appliqué à l'invention est spécifique et original par rapport à l'état actuel de la technique.

Une fois les poids initiaux $w_g$ du premier réseau de neurones 32 et du deuxième réseau de neurones 34 respectivement déterminés, le méta-apprentissage MAML met en œuvre une étape d'inférence 42 en ligne (i.e. de méta-adaptation) correspondant à la méta-adaptation des poids initiaux $w_g$ du premier réseau de neurones 32 et du deuxième réseau de neurones 34 respectivement en poids optimaux $w_{opt}$ adaptés aux seules données associées à la configuration d'utilisation courante de l'amplificateur de puissance 20, ce qui permet une adaptation rapide à partir d'un ensemble $T_t$ de données limitées, en évitant la mise en œuvre classique d'une initialisation aléatoire, les poids optimaux $w_{opt}$ étant obtenus sous la forme suivante :

$$w_{opt}^k = w_{opt}^{k-1} - \nabla_{w_{opt}^{k-1}} L\left(w_{opt}^{k-1}, D^{tr}\right) \qquad (12)$$

avec k = 1, ..., *M* , M étant le nombre d'étapes de descente de gradient en considérant que $w_{opt}^0 = w_g$ et $D^{tr}$ le sous-ensemble de données d'entrainement (i.e. d'apprentissage) de la tache de prédiction $T_t$ à l'instant t associée au cas d'utilisation courant de l'amplificateur de puissance.

Selon un aspect particulier, le module d'optimisation 36 est propre à mettre en œuvre un optimiseur ADAM pour optimiser l'étape de méta-adaptation 42.

A titre optionnel, pour accélérer et assurer la convergence du méta-apprentissage MAML, il est possible selon la présente invention de remplacer les optimiseurs propres à mettre en œuvre une descente de gradient stochastique SGD (de l'anglais *Stochastic Gradient Descent*) selon les équations (9) et (11) par des optimiseurs tels que les optimiseurs ADAM ou RADAM précités, propres à améliorer la convergence en adaptant le ou les taux d'apprentissage (interne et/ou externe), et propres à mettre en œuvre une descente de gradient stochastique SGD selon des équations distinctes des équations (9) et (11) précitées.

A titre optionnel, il est encore possible d'améliorer le méta-apprentissage MAML, en optimisant la perte externe après chaque boucle interne au lieu de l'optimiser une fois l'ensemble des boucles internes effectuées, ce qui permet notamment d'améliorer la stabilité du gradient.

D'autres optimisations du méta-apprentissage MAML, telles que celles introduites par A. Antoniou et al. dans l'article intitulé « *How to train your MAML* » pourraient également être mises en œuvre à titre d'amélioration de la présente invention.

La figure 4 illustre le fonctionnement du module d'acquisition de données 38 optionnel du dispositif de linéarisation, par prédistorsion numérique selon la présente invention. En particulier, le module d'acquisition de données 38 configuré pour alimenter, pour chaque tâche de prédiction, chaque groupe associé de données de fonctionnement distinct de l'ensemble de données de l'amplificateur de puissance 20 en prélevant en sortie de l'émetteur radiofréquence 16 et/ou en sortie de l'amplificateur de puissance 20 un nombre prédéterminé de symboles, l'ensemble 48 des symboles prélevés étant conforme à une distribution statistique en amplitude prédéterminée dudit nombre prédéterminé de symboles.

L'utilisation d'un tel module 38 d'acquisition vise à optimiser (i.e. déterminer avec soin) la quantité de données de chaque groupe de données associé à une tache de prédiction, chaque tâche de prédiction caractérisant une variation de comportement de l'amplificateur de puissance 20, une telle variation étant par exemple associée à une température d'utilisation particulière, un courant et/ou une tension d'alimentation propre(s), une adaptation de l'antenne d'émission, une pression d'utilisation, ou une combinaison d'au moins deux de ces facteurs, variation se traduisant alors théoriquement par une variation du facteur p de transition (de l'anglais *knee factor)* du modèle théorique de Rapp tel qu'exprimé précédemment à l'aide de l'équation (3).

En particulier, la pluralité de tâches de prédiction propres à être utilisées selon la présente invention est représentative d'un facteur p de transition tel que p $\in$ [0,7,1,5] avec par exemple p = 0,7 + 0,05j, $j \in$ [0,17], ce qui correspond à l'utilisation de dix-sept tâches de prédiction distinctes associées respectivement à dix-sept configurations d'utilisation de l'amplificateur de puissance 20 distinctes par un ou plusieurs paramètres d'utilisation tel que la température d'utilisation particulière, un courant et/ou une tension d'alimentation propre(s), une adaptation de l'antenne d'émission, une pression d'utilisation, ou une combinaison d'au moins deux de ces facteurs, pour alors théoriquement se traduire par une variation du facteur p de transition correspondant. Ces dix-sept tâches de prédiction distinctes sont selon la présente invention suffisantes pour obtenir une convergence optimale du méta-apprentissage MAML.

Il est à noter que selon la présente invention, utiliser une distribution de tâches de prédiction plus importante (i.e. avec un nombre de tâches de prédiction plus important) n'est pas recommandé car propre à comprendre un nombre de configurations de modèles non-linéaire de fonctionnement de l'amplificateur de puissance insuffisant ce qui rendrait le méta-modèle précis sur les configurations de modèles linéaires et moins précis sur les modèles non-linéaires, et donc moins propres à permettre de corriger les non-linéarités introduites par l'amplificateur de puissance 20, et ce tout en augmentant le temps de traitement.

De plus, pour une convergence optimale du module d'optimisation 36 mettant en œuvre un méta-apprentissage MAML, un nombre prédéterminé $B$ = 1000$k$, avec $k \in$ [1,10] de symboles par sous-ensemble $D_i^{tr}$ de données d'entrainement (i.e. d'apprentissage), et par sous-ensemble $D_i^{te}$ de données test de chaque tâche de prédiction est préférentiellement utilisé, en particulier $B$ tel que 2000 < $B$ < 5000, et par exemple avantageusement B = 3000 symboles OFDM d'entrée 48 et de sortie 50 de l'amplificateur de puissance 20, lorsqu'un émetteur OFDM 16 est mis en œuvre, ces 3000 symboles OFDM étant par exemple répartis en lots de 1000 symboles OFDM, chaque lot étant associé à une itération (de l'anglais *gradient step*) de la boucle interne de la descente de gradient du méta-apprentissage, qui de fait comprend trois itérations lors de la phase d'entrainement des réseaux de neurones 32 et 34.

Utiliser davantage de boucles internes en entrainement ne permettrait en effet pas d'améliorer efficacement les performances finales du dispositif 18 de linéarisation, par prédistorsion numérique et ralentirait son traitement. Selon cet exemple, la quantité total de données consommées pour l'entrainement de chaque réseau de neurones 32 et 34 serait, selon un estimation par simulation numérique, sensiblement égale à 51 000 symboles OFDM avec un nombre d'époques de l'ordre de 250 et des taux d'apprentissage interne $\varepsilon$ et externe $\mu$ respectivement égaux à 10⁻³, et 5.10⁻⁴.

En outre, tel qu'illustré par la figure 4, la présente invention, via le module 38 d'acquisition propose d'optimiser la construction de chaque groupe de B données associées à chaque sous-ensemble de données $D_i^{tr}$, $D_i^{te}$ de chaque tâche de prédiction, en vérifiant via un module de vérification 52 du module 38 d'acquisition que chaque symbole 48 d'entrée de l'amplificateur de puissance 20est conforme à une distribution statistique en amplitude D prédéterminée du nombre B de symboles à prélever pour couvrir entièrement le modèle de fonctionnement considéré de l'amplificateur de puissance 20.

Une telle distribution statistique en amplitude D est notamment obtenue au préalable, notamment en tenant compte de la modulation mise en oeuvre, par exemple une 64-QAM. Sur la figure 4, une telle distribution statistique en amplitude D est illustrée par la représentation 54 et définit une répartition des B symboles par niveau d'amplitude, et ce en regard des fonctions de transfert 58, 60, et 62 respectivement associées à l'amplificateur de puissance 20, au dispositif 18 de linéarisation, par prédistorsion numérique, et à l'ensemble résultant de la combinaison du dispositif de linéarisation par prédistorsion numérique 18 suivi de l'amplificateur de puissance 20, ces fonctions de transfert illustrant la zone excitée de l'amplificateur de puissance 20 associée à chaque classe de l'histogramme de la distribution statistique en amplitude D.

Par exemple, la distribution statistique en amplitude D comprend deux symboles d'amplitude égale à un (ou comprise entre zéro et un), quatre symboles d'amplitude égale à deux (ou comprise entre un et deux), cinq symboles d'amplitude égale à trois (ou comprise entre deux et trois), huit symboles d'amplitude égale à quatre (ou comprise entre trois et quatre), etc.

Lorsqu'un symbole d'entrée 48 de l'amplificateur de puissance 20 est conforme à la distribution D, un commutateur 64 autorise l'acquisition de ce symbole d'entrée 48 dans un sous-ensemble de donnée 66, ainsi que l'acquisition du symbole de sortie 50 correspondant à ce symbole d'entrée 48 dont l'acquisition est autorisée.

Selon l'exemple précédent de distribution statistique en amplitude D, le symbole d'entrée 48 entrant dans le module de vérification 52 présente par exemple une amplitude égale à deux, et le sous-ensemble de donnée 66 comprend déjà trois symboles OFDM d'amplitude égale à deux sur quatre symboles autorisés selon la distribution statistique en amplitude D. Il reste donc une place dans le sous-ensemble de donnée 66 selon la distribution statistique en amplitude D, et le module de vérification 52 commande le commutateur 64 pour autoriser l'acquisition de ce symbole d'entrée 48, et compléter le nombre B de symboles à prélever en termes de symboles présentant une amplitude égale à deux.

En revanche, lorsqu'un symbole 48 suivant entrant dans le module de vérification 52 présente également une amplitude égale à deux, le module de vérification 52 commande le commutateur 64 pour rejeter l'acquisition de ce symbole d'entrée 48 suivant, le nombre B de symboles à prélever en termes de symboles présentant une amplitude égale à deux étant déjà complet pour ce niveau d'amplitude (i.e. la colonne associée au niveau d'amplitude deux de l'histogramme D étant déjà complète en termes de nombre de symboles).

Ainsi, le module d'acquisition 38 permet de prélever uniquement les symboles pertinents pour satisfaire la distribution statistique en amplitude D, un tel module d'acquisition étant propre à être mis en œuvre hors ligne et en ligne, et de minimiser ainsi l'utilisation de donnée tout en s'assurant que le sous-ensemble de donnée 66 est suffisamment pertinent en étant conforme à la distribution statistique en amplitude D.

De manière non représentée, la présente invention porte également sur un procédé de linéarisation, par prédistorsion numérique adaptative, d'un amplificateur de puissance 20 du système de communication 10 comprenant un émetteur radiofréquence propre à transmettre au moins une trame de symboles précédemment décrit en relation avec la figure 1, le procédé selon la présente invention étant mis en œuvre par le dispositif 18 de linéarisation, par prédistorsion numérique précédemment décrit.

Plus précisément, un tel procédé selon la présente invention comprend une étape, non représentée, de prédistorsion numérique du signal fourni par l'émetteur radiofréquence 16 en déterminant une prédistorsion polaire à appliquer audit signal par mise en œuvre d'une étape d'inférence par :

- le premier réseau 32 de neurones configuré pour corriger une distorsion en amplitude associée à l'amplificateur de puissance ; et
- le deuxième réseau 34 de neurones configuré pour corriger une distorsion en phase associée à l'amplificateur de puissance.

De plus, le procédé selon la présente invention comprend une étape d'optimisation du premier réseau de neurones et d'optimisation du deuxième réseau de neurones par :

- méta-apprentissage du premier réseau de neurones, et
- méta-apprentissage du deuxième réseau de neurones,

chaque méta-apprentissage étant mis en œuvre à partir d'un ensemble de données de fonctionnement de l'amplificateur de puissance, chaque méta-apprentissage comprenant une pluralité de tâches de prédiction distinctes respectivement associées à des groupes de données de fonctionnement et de métadonnées distincts de l'ensemble de données, les groupes distincts étant représentatifs de cas distincts d'utilisation de l'amplificateur de puissance,

le méta-apprentissage du premier réseau de neurones, et le méta-apprentissage du deuxième réseau de neurones, comprenant :

- à partir d'une première partie dudit ensemble de données préalablement obtenue, une méta-initialisation du premier réseau de neurones, respectivement du deuxième réseau de neurones, fournissant au préalable une initialisation des poids initiaux du premier réseau de neurones, respectivement du deuxième réseau de neurones ;
- à partir desdits poids initiaux et d'une deuxième partie dudit ensemble de données correspondant au cas d'utilisation courant de l'amplificateur de puissance, une méta-adaptation des poids initiaux en poids optimaux du premier réseau de neurones 32, respectivement du deuxième réseau de neurones 34.

Il est à noter que les variantes de réalisation décrites précédemment en relation avec le dispositif 18 de linéarisation, par prédistorsion numérique précédemment décrit s'applique de manière similaire au procédé selon la présente invention.

L'homme du métier comprendra que l'invention ne se limite pas aux modes de réalisation décrits, ni aux exemples particuliers de la description, les modes de réalisation et les variantes mentionnées ci-dessus étant propres à être combinés entre eux pour générer de nouveaux modes de réalisation de l'invention.

La présente invention propose ainsi une solution pour adapter rapidement la linéarisation, par prédistorsion numérique, d'un amplificateur de puissance à toute configuration d'utilisation de l'amplificateur de puissance, et ce avec une faible complexité ce qui permet d'économiser les ressources de calcul mise en œuvre, et par conséquent la puissance de calcul associée.

En particulier, la présente invention tire profit d'une part d'une décomposition polaire des traitements par réseaux de neurones en utilisant séparément deux réseaux de neurones de faible complexité (comprenant notamment dix neurones chacun) conçus sur mesure et dédiés respectivement à la correction des distorsions en amplitude et en phase introduites par l'amplificateur de puissance, et d'autre part d'un méta-apprentissage permettant de limiter le temps d'adaptation des poids optimaux de chaque réseau en cas de changement de configuration d'utilisation tout en restant performant en termes de linéarisation, un tel méta-apprentissage n'ayant pas été utilisé jusqu'ici pour optimiser la linéarisation par prédistorsion numérique d'un amplificateur de puissance.

En outre, optionnellement, la présente invention propose une acquisition de données d'apprentissage optimisée pour prélever un nombre de données optimal et limité tout en assurant que les données ainsi prélevées permettent un apprentissage performant et convergent.

**Revendications**

1. Dispositif (18) de linéarisation, par prédistorsion numérique, d'un amplificateur de puissance d'un système de communication comprenant au moins un émetteur radiofréquence propre à transmettre au moins une trame de symboles, le dispositif de linéarisation comprenant :

   - un module (30) de prédistorsion numérique du signal fourni par l'émetteur radiofréquence configuré pour déterminer en inférence une prédistorsion dans le domaine polaire à appliquer audit signal, le module de prédistorsion, présentant une architecture d'apprentissage indirect par réseau de neurones, et comprenant :

     - un premier réseau de neurones (32) configuré pour corriger une distorsion en amplitude produite par l'amplificateur de puissance en recevant en entrée l'amplitude de la sortie $|y|$ de l'amplificateur de puissance (20), le premier réseau de neurones (32) étant propre à fournir une fonction réciproque $\widehat{f_\rho^{-1}}$ de la fonction de distorsion en amplitude produite par l'amplificateur de puissance ;
     - un deuxième réseau de neurones (34) configuré pour corriger une distorsion en phase produite par l'amplificateur de puissance en recevant en entrée l'amplitude de l'entrée $|x|$ de l'amplificateur de puissance (20), le deuxième réseau de neurones (34) étant propre à fournir une fonction de phase $f_{\_\Phi}$ délivrant l'opposé en phase de chaque phase ;

   **caractérisé en ce que** le dispositif de linéarisation comprend en outre :

- un module d'optimisation (36) du premier réseau de neurones (32) et d'optimisation du deuxième réseau de neurones (34) configuré pour mettre en oeuvre :

- un méta-apprentissage du premier réseau de neurones (32), et
- un méta-apprentissage du deuxième réseau de neurones (34),

le module d'optimisation (36) étant configuré pour mettre en œuvre chaque méta-apprentissage à partir d'un ensemble de données de fonctionnement de l'amplificateur de puissance, chaque méta-apprentissage comprenant une pluralité de tâches de prédiction distinctes respectivement associées à des groupes de données de fonctionnement et de métadonnées distincts de l'ensemble de données, les groupes distincts étant représentatifs de cas distincts d'utilisation de l'amplificateur de puissance,
le module d'optimisation (36) étant configuré pour mettre en œuvre le méta-apprentissage du premier réseau de neurones (32), et le méta-apprentissage du deuxième réseau de neurones (34), en utilisant :

- à partir d'une première partie dudit ensemble de données préalablement obtenue, une méta-initialisation du premier réseau de neurones, respectivement du deuxième réseau de neurones, fournissant au préalable une initialisation des poids initiaux ($w_g$) du premier réseau de neurones, respectivement du deuxième réseau de neurones ;
- à partir desdits poids initiaux ($w_g$) et d'une deuxième partie ($T_t$) dudit ensemble de données correspondant au cas d'utilisation courant de l'amplificateur de puissance, une méta-adaptation des poids initiaux en poids optimaux ($w_{opt}$) du premier réseau de neurones, respectivement du deuxième réseau de neurones ;

le module d'optimisation (36) étant propre à entrainer le premier réseau de neurones (32) et le deuxième réseau de neurones (34) en optimisant une fonction de coût.

2. Dispositif (18) selon la revendication 1, dans lequel le premier réseau de neurones (32), configuré pour corriger une distorsion en amplitude produite par l'amplificateur de puissance (20), reçoit en entrée l'amplitude de la sortie $|y|$ de l'amplificateur de puissance (20), le premier réseau de neurones (32) étant propre à fournir une fonction réciproque $\widehat{f_\rho^{-1}}$ de la fonction de distorsion en amplitude produite par l'amplificateur de puissance telle que :

$$\widehat{f_\rho^{-1}}(|y|) = g_0(|y|) + g_1(|y|)$$

avec :

$$g_0(|y|) = \gamma_0(|y|) + \left(1 - \gamma_0(|y|)\right)|y| \text{ où } \gamma_0(|y|) = (1 + e^{-\alpha(|y|-\omega_\rho)})^{-1},$$

et

$$g_1(|y|) = \sum_{j=1}^{N_n^\rho} \omega_j^\rho [ReLu(W_\rho |y| + b_\rho)]_j$$

où $\alpha, \omega_\rho, \omega_j^\rho \in \mathbb{R}$, $W_\rho \in \mathbb{R}^{1 \times N_n^\rho}$ et $b_\rho \in \mathbb{R}^{1 \times N_n^\rho}$ sont les poids du premier réseau de neurones dont la valeur initiale est optimisée par méta-apprentissage, *ReLu* est la fonction d'activation d'unité de rectification linéaire, et où $N_n^\rho$ correspond au nombre de neurones du premier réseau de neurones.

3. Dispositif (18) selon la revendication 1 ou 2, dans lequel dans lequel le deuxième réseau de neurones (34), configuré pour corriger une distorsion en phase produite par l'amplificateur de puissance (20), reçoit en entrée l'amplitude de l'entrée $|x|$ de l'amplificateur de puissance (20), le deuxième réseau de neurones (34) étant propre à fournir une fonction de phase $f\_\varphi$ délivrant l'opposé en phase de chaque phase telle que :

$$f_{-\Phi}(|x|) = \gamma_1(|x|)g_2(|x|)$$

avec :

$$\gamma_1(|x|) = (1 + e^{-\beta(|x|-\omega_\Phi)})^{-1} \text{ et } g_2(|x|) = \sum_{j=1}^{N_n^\Phi} \omega_j^\Phi [ReLu(W_\Phi |x| + b_\Phi)]_j$$

où $\beta$, $\omega_\Phi$, $\omega_j^\Phi \in \mathbb{R}$, $W_\Phi \in \mathbb{R}^{1\times N_n^\Phi}$ et $b_\Phi \in \mathbb{R}^{1\times N_n^\Phi}$ sont les poids du deuxième réseau de neurones dont la valeur initiale est optimisée par méta-apprentissage, *ReLu* est la fonction d'activation d'unité de rectification linéaire, et où $N_n^\Phi$ correspond au nombre de neurones du deuxième réseau de neurones (34).

4.  Dispositif (18) selon l'une quelconque des revendications précédentes, dans lequel chaque tâche de prédiction distincte est au moins associée à une valeur distincte caractérisant une variation de comportement de l'amplificateur de puissance (20).

5.  Dispositif (18) selon l'une quelconque des revendications précédentes, dans lequel le module d'optimisation (36) est configuré pour mettre en œuvre un méta-apprentissage des poids du premier réseau de neurones (32), et/ou un méta-apprentissage des poids du deuxième réseau de neurones (34), en utilisant un méta-apprentissage agnostique au modèle de réseau(x) de neurones utilisé(s).

6.  Dispositif (18) selon l'une quelconque des revendications précédentes, dans lequel le module d'optimisation (36) est propre à entrainer le premier réseau de neurones (32) et le deuxième réseau de neurones (34) en optimisant une fonction de coût correspondant à l'erreur quadratique moyenne au moyen d'un optimiseur ADAM ou RADAM.

7.  Dispositif (18) selon l'une quelconque des revendications précédentes comprenant en outre un module (38) d'acquisition de données configuré pour alimenter chaque groupe de données de fonctionnement et de métadonnées distincts de l'ensemble de données de l'amplificateur de puissance (20) en prélevant en sortie de l'émetteur radiofréquence (16) un nombre prédéterminé de symboles, l'ensemble des symboles prélevés étant conforme à une distribution statistique en amplitude prédéterminée dudit nombre prédéterminé de symboles.

8.  Système (10) de communication comprenant au moins successivement :

    - un modulateur radiofréquence (14) ;
    - un émetteur (16) radiofréquence propre à transmettre au moins une trame de symboles dont l'entrée est connectée à la sortie du modulateur de fréquence ;
    - un dispositif (18) de linéarisation par prédistorsion numérique selon l'une quelconque des revendications précédentes, l'entrée du dispositif de linéarisation étant connectée à la sortie dudit émetteur radiofréquence ; et
    - un amplificateur de puissance (20) dont l'entrée est connectée à la sortie du dispositif de linéarisation,

    le système de communication comprenant une boucle de rétroaction de l'amplificateur de puissance (20) vers le dispositif de linéarisation (18).

9.  Procédé de linéarisation, par prédistorsion numérique adaptative, d'un amplificateur de puissance d'un système de communication comprenant un émetteur radiofréquence propre à transmettre au moins une trame de symboles, le procédé étant **caractérisé en ce qu'**il comprend les étapes suivantes :

    - une étape de prédistorsion numérique du signal fourni par l'émetteur radiofréquence en déterminant une prédistorsion polaire à appliquer audit signal par mise en œuvre d'une étape d'inférence par :

        - un premier réseau de neurones configuré pour corriger une distorsion en amplitude associée à l'amplificateur de puissance ; et
        - un deuxième réseau de neurones configuré pour corriger une distorsion en phase associée à l'amplificateur de puissance,

- une étape d'optimisation du premier réseau de neurones et d'optimisation du deuxième réseau de neurones par :

    - méta-apprentissage du premier réseau de neurones, et
    - méta-apprentissage du deuxième réseau de neurones,

chaque méta-apprentissage étant mis en œuvre à partir d'un ensemble de données de fonctionnement de l'amplificateur de puissance, chaque méta-apprentissage comprenant une pluralité de tâches de prédiction distinctes respectivement associées à des groupes de données de fonctionnement et de métadonnées distincts de l'ensemble de données, les groupes distincts étant représentatifs de cas distincts d'utilisation de l'amplificateur de puissance,
le méta-apprentissage du premier réseau de neurones, et le méta-apprentissage du deuxième réseau de neurones, comprenant :

    - à partir d'une première partie dudit ensemble de données préalablement obtenue, une méta-initialisation du premier réseau de neurones, respectivement du deuxième réseau de neurones, fournissant au préalable une initialisation des poids initiaux du premier réseau de neurones, respectivement du deuxième réseau de neurones ;
    - à partir desdits poids initiaux et d'une deuxième partie dudit ensemble de données correspondant au cas d'utilisation courant de l'amplificateur de puissance, une méta-adaptation des poids initiaux en poids optimaux du premier réseau de neurones, respectivement du deuxième réseau de neurones.

**10.** Programme d'ordinateur comportant des instructions logicielles qui, lorsqu'elles sont exécutées par un ordinateur, mettent en œuvre le procédé de linéarisation selon la revendication 9.

**FIG.1**

FIG.2

**FIG.3**

FIG.4

EP 4 117 178 A1

Europäisches
Patentamt

European
Patent Office

Office européen
des brevets

# RAPPORT DE RECHERCHE EUROPEENNE

Numéro de la demande

EP 22 18 2935

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | POCHMARA J: "Improving compensation of nonlinear distortions in OFDM system using recurrent neural network with conjugate gradient algorithm", PERSONAL, INDOOR AND MOBILE RADIO COMMUNICATIONS, 2004. PIMRC 2004. 15 TH IEEE INTERNATIONAL SYMPOSIUM ON BARCELONA, SPAIN 5-8 SEPT. 2004, PISCATAWAY, NJ, USA,IEEE, PISCATAWAY, NJ, USA, vol. 1, 5 septembre 2004 (2004-09-05), pages 180-185, XP010754584, DOI: 10.1109/PIMRC.2004.1370860 ISBN: 978-0-7803-8523-8 * alinéa [000I] – alinéa [00VI]; figures 1-7 * | 1-10 | INV. H03F1/32 G06N3/08 H03F3/189 H03F3/24 H04B1/04 H04L27/36 |
| A | WATKINS B E ET AL: "Predistortion of nonlinear amplifiers using neural networks", MILITARY COMMUNICATIONS CONFERENCE, 1996. MILCOM '96, CONFERENCE PROCE EDINGS, IEEE MCLEAN, VA, USA 21-24 OCT. 1996, NEW YORK, NY, USA,IEEE, US, vol. 1, 21 octobre 1996 (1996-10-21), pages 316-320, XP010204004, DOI: 10.1109/MILCOM.1996.568636 ISBN: 978-0-7803-3682-7 * alinéa [000I] – alinéa [00VI]; figures 1-4 * | 1-10 | DOMAINES TECHNIQUES RECHERCHES (IPC) H03F G06N H04L H04B |

-/--

Le présent rapport a été établi pour toutes les revendications

| Lieu de la recherche | Date d'achèvement de la recherche | Examinateur |
|---|---|---|
| La Haye | 10 novembre 2022 | Rafflenbeul, A |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
.................................................
& : membre de la même famille, document correspondant

EPO FORM 1503 03.82 (P04C02)

Europäisches
Patentamt

European
Patent Office

Office européen
des brevets

**RAPPORT DE RECHERCHE EUROPEENNE**

Numéro de la demande

**EP 22 18 2935**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | IBNKAHLA M: "Neural network predistortion technique for digital satellite communications", ACOUSTICS, SPEECH, AND SIGNAL PROCESSING, 2000. ICASSP '00. PROCEEDING S. 2000 IEEE INTERNATIONAL CONFERENCE ON 5-9 JUNE 2000, PISCATAWAY, NJ, USA,IEEE, vol. 6, 5 juin 2000 (2000-06-05), pages 3506-3509, XP010505653, ISBN: 978-0-7803-6293-2 * alinéa [0001] – alinéa [0005]; figures 1-6 * | 1-10 | |
| A | DENG XIANG ET AL: "Is the Meta-Learning Idea Able to Improve the Generalization of Deep Neural Networks on the Standard Supervised Learning?", 2020 25TH INTERNATIONAL CONFERENCE ON PATTERN RECOGNITION (ICPR), IEEE, 10 janvier 2021 (2021-01-10), pages 150-157, XP033909896, DOI: 10.1109/ICPR48806.2021.9412047 * alinéa [0001] – alinéa [0005]; figures 1-8 * | 1-10 | DOMAINES TECHNIQUES RECHERCHES (IPC) |

Le présent rapport a été établi pour toutes les revendications

| Lieu de la recherche | Date d'achèvement de la recherche | Examinateur |
|---|---|---|
| La Haye | 10 novembre 2022 | Rafflenbeul, A |